# EUROPEAN PATENT SPECIFICATION

(11) **EP 2 943 611 B1**
(45) Date of publication and mention of the grant of the patent: **12.04.2017**
(21) Application number: 14700128.3
(22) Date of filing: 13.01.2014
(51) Int. Cl.: D06M 11/83, C08J 5/04, B32B 5/26

(54) **FERROMAGNETIC FIBRE COMPOSITES**
FERROMAGNETISCHE FASERVERBUNDWERKSTOFFE
COMPOSITES DE FIBRES FERROMAGNÉTIQUES

(30) Priority: 14.01.2013 GB 201300572
(43) Date of publication of application: 18.11.2015
(73) Proprietor: BAE SYSTEMS plc, London SW1Y 5AD (GB)
(72) Inventor: HAQ, Sajad, Bristol South Gloucestershire BS34 7QW (GB); DUNLEAVY, Michael, Bristol South Gloucestershire BS34 7QW (GB); DYKE, Hazel Anne, Bristol South Gloucestershire BS34 7QW (GB); DYKE, Amy Elizabeth, Bristol South Gloucestershire BS34 7QW (GB)
(74) Representative: BAE SYSTEMS plc Group IP Department
(86) International application number: PCT/GB2014/050086
(87) International publication number: WO 2014/108704

(56) References cited:
- WO-A1-2008/148543
- JP-A- S60 235 843
- US-A- 4 471 015
- US-A- 4 515 850
- US-A- 5 853 882
- US-A1- 2009 142 545

## Description

The invention relates to ferromagnetic fibre composites, particularly ferromagnetic coated fibre plies in fibre reinforced polymer composites (FRPC), more preferably to a ferromagnetic FRPC, and composites with a plurality of functionalised fibre layers.

Fibre reinforced polymer composites (FRPC) are finding increased use in structures or as replacement panels, such as, for example replacement panels on vehicles, vessels or crafts, to provide lighter and stronger materials than conventional metal panels. WO 20101120426 discloses a polymer composite with metal coated fibres, which are formed by mordanting the surface of the fibres with a concentrated acid.

Ferromagnetic composite structures are known from WO 2008/148543, US 2009/0142545, US 4,515,850 and JPS60235843.

According to a first aspect of the invention there is provided a ferromagnetic composite structure comprising at least one ferromagnetic fibre ply, wherein said ferromagnetic fibre ply is substantially encapsulated in a binder matrix to form a ferromagnetic fibre reinforced polymer composite, wherein said at least one ferromagnetic fibre ply comprises a fibre ply comprising at least one layer of a ferromagnetic material characterised wherein there is a layer of at least one metal or ionic metal compound nucleation material between the fibre ply and the layer of ferromagnetic material.; preferably the ferromagnetic material is selected from iron, nickel, cobalt, alloys thereof, or rare earth salts.

The layer of ferromagnetic material may cover part, substantially all or all of the fibre ply. The layer of a ferromagnetic material may be in the form a pattern on the at least one surface of the fibre ply. The pattern may be any shape, repeat unit or image, such as, for example a motif, or a frequency selective surface, such as, for example a patch antenna array. There is at least one layer of a nucleation material between the fibre ply and the layer of ferromagnetic material, the nucleation material being a metal or ionic metal compound, preferably the metal/ionic compound is silver or gold.

The layer of ferromagnetic material may be deposed to a thickness which is less than the diameter of the fibres within said ply; preferably the ferromagnetic material is deposed to a thickness in the range of 0.1 to 10 microns, preferably in the range of from 5 to 10 microns.

The layer of ferromagnetic material may be magnetised, or be caused to be temporarily magnetised by causing the material to be an electromagnetic, by subjecting said ferromagnetic material to an electrical field. Aligning the magnetic field permanently or temporarily may enhance the magnetic properties of the material.

FRPCs typically comprise a plurality of fibre plies to impart strength to the final composite. The ferromagnetic composite structure preferably comprises at least one further fibre ply. The ferromagnetic composite may comprise at least one metallic fibre ply, which is formed from a further fibre ply with at least one layer of at least one non-ferromagnetic metallic material.

The multiplicity of fibre plies, fibre plies provides the structural rigidity to the final composite, the use of different functionalised fibre plies, such as for example, untreated, metallic, ferromagnetic, provides function to the final composite. The composite may be arranged as interspersed ferromagnetic fibre plies between a plurality of fibre plies, the plurality of at least one fibre plies provides significant structural strength to the final panel. The use of one or two functionalised layers, i.e. the ferromagnetic fibre ply, minimises the overall mass of the final composite. There may be a plurality of functionalised fibre layers with the ferromagnetic composite, each layer providing separate function to the final polymer composite.

The binder matrix may be selected from any commonly used resin binder or ceramic binder for fibre reinforced polymer composite manufacture, such as, for example, an epoxy resin or alumina.

The binder matrix may comprise particulate fillers, preferably conductive particulate fillers, more preferably metallic particulate fillers, yet more preferably particulate fillers comprising ferromagnetic materials, such as for example iron particulates.

The at least one fibre ply may be selected from any combination of woven or non-woven fabrics, and may be selected from any material, such as for example, carbon, glass, ceramic, boron silicon carbide fibres, textile fibres or polymers, such as, for example aramids, polyolefins, and may be selected depending on the desired mechanical or physical properties of the device.

The at least one fibre ply may be a standard fibre ply which can be used with a separate binder matrix, such as, for example, a liquid resin or ceramic. Conveniently the use of a pre-preg (pre-impregnated with binder matrix) ferromagnetic fibre ply is used to facilitate layup of the device and subsequent manufacture.

According to a further aspect of the invention there is provided a method of manufacturing a ferromagnetic FRPC comprising a non-conductive fibre ply, including the steps of providing at least one non-conductive fibre ply to be treated,
deposing at least one layer of a at least one metal or ionic metal compound nucleation material onto at least one surface of the at least one non-conductive fibre ply to be treated, to form a primed non-conductive fibre ply,
causing deposition of a layer of ferromagnetic material onto said primed non-conductive fibre ply, preferably the deposition is ionic deposition.

The at least one layer of nucleation material may be deposed such that it covers all of the non-conductive fibre ply to be treated, or it may be deposed in the form of a pattern on at least one surface of the at least one non-conductive fibre ply to be treated. The pattern may be any shape, repeat unit or image, such as, for example a motif, or a frequency selective surface, such as, for example a patch antenna array Thereby the final deposition of the layer of a ferromagnetic material may only occur on the regions coated by the nucleation material.

The nucleation material may be applied to the fibre by any known deposition methods, such as, for example by brush, dipping, spraying, or a controlled printing process.

The pattern may be applied by actively depositing the nucleation material only on the required areas, such as by use of a mask or an active printing nozzle, such as via a printer.

Alternatively, a pattern may be formed by removing the unwanted portions of the deposed nucleation material, using standard lithography techniques.

The ionic deposition of the layer of a ferromagnetic material may be via any known technique, such as, for example electrodeposition or electroless deposition. The deposing solution may use, iron II chloride, iron II sulphate or sodium citrate. Non-ionic deposition such as for example chemical vapour deposition may also be employed. These techniques are typical bulk deposition methods, therefore where a pattern is required; preferably said pattern will be applied to a primed non-conductive fibre ply with the pattern formed from at least one metal or ionic metal compound, already imparted thereon. The specific use of deposed silver as the nucleation material provides a highly conductive and inert support layer for the ferromagnetic material. The silver layer promotes when deposed on a non-conductive ply facilitates ionic deposition of the layer of ferromagnetic magnetic material, thus removing the need for preparing the surface of the non-conductive fibre ply by using an acid wash surface treatment. Carbon fibre plies or fibre plies made from a conductive material may also be primed with at least one layer of a nucleation material, to assist with deposition of the ferromagnetic material.

The ferromagnetic fibre ply may be subjected to further chemical preparations, coatings or protective layers.

Devices according to the invention may be used in new designs or to replace worn, damaged or outdated parts of any items which can be manufactured of a metallic material. Conveniently, where the device is used to replace a panel on an existing body, vehicle, vessel or craft, the device may preferably be engineered to the same dimensions as the original panel.

The device may be used to replace structural panels on a vehicle vessel or craft, such further potential uses on vehicles may include body panels on hybrid or electric drive vehicles where the devices of the invention can be used to save weight and bulk, compared to conventional devices. Such devices may also find use on free flooding hydrodynamic hulls of, say, submersible remotely operated vehicles. The devices would be especially useful on any vehicle where weight or bulk was at a premium like an aircraft or a satellite. On a satellite the saving in space and bulk of devices according to the invention which could be used to transfer heat or cooling to various systems and may extend service life of the satellite substantially.

Of potential great importance would be the use of devices according to the invention in electrical or electronic equipment, in particular portable equipment such as computers, personal digital assistants (PDAs), cameras and telephones. Here mountings for such equipment such as circuit boards, casings and the like could be made according to the invention which would, again, assist in cutting down the weight and bulk of such items enabling them to be lighter, smaller and possibly cheaper, owing to the reduced part count.

The composite structures may find particular use on large structure such as wind turbines.

Whilst the invention has been described above, it extends to any inventive combination of the features set out above, or in the following description, drawings or claims.

Exemplary embodiments of the device in accordance with the invention will now be described with reference to the accompanying drawings in which:-
Figure 1 shows a partially primed and partially ferromagnetic coated fibre ply
Figure 2 shows fibre reinforced polymer composite.

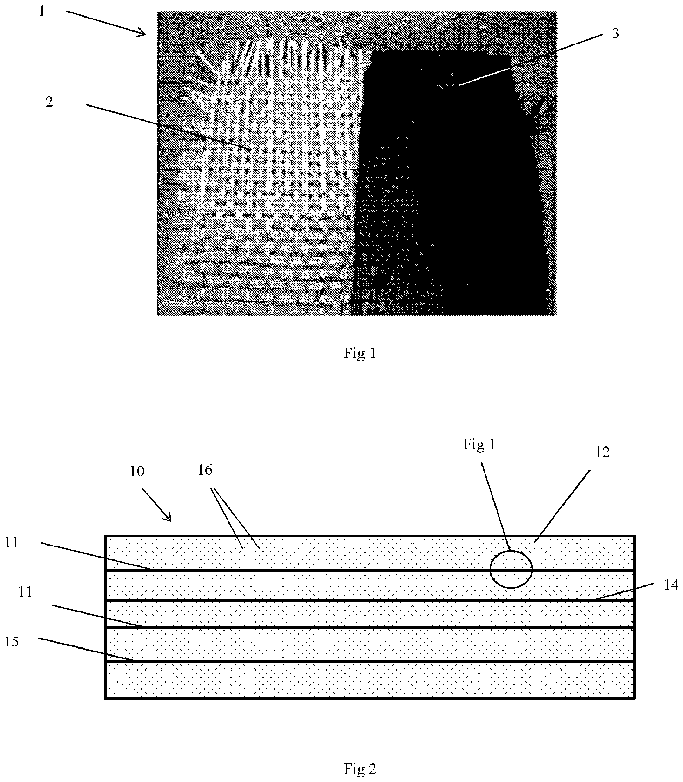

Turning to Figure 1 shows a fibre ply 1, which has been sprayed with conductive silver loaded paint to provide a silver layer 2, on the fibre 1. Part of the fibre ply has been subjected to an electroless deposition with an iron containing electrolyte to provide a layer of ferromagnetic material 3, in this case iron.

Figure 2 shows an example of a composite structure depicted generally at 10, comprising a ferromagnetic fibre ply 11, as described in figure 1, optionally standard fibre ply 14, optionally a metallic coated fibre ply (non-ferromagnetic metal) 15. The fibre plies (11, 14, 15) are encapsulated in a resin binder 12 to form the composite structure 10. The resin binder 12 may also contain filler particulates 16, which may also be ferromagnetic particulates.

The layers are not necessarily planar. Non-planar configurations may be employed, for example, to provide a curved or even a generally tubular device structure, or to provide devices which can be shaped to any currently existing shaped panel. The structures of the invention are well suited for such configurations.

### Experimental

### Experiment 1

A conductive silver paint was sprayed onto glass fabric (200gsm, plain weave) good coverage was achieved with 4-6 passes, to provide a layer of silver metal. Both sides of the fabric were sprayed, and left to dry for 12-24 hrs.

The silver coated fabric was then connected to a power supply via an electrical connection, such as a clip or foil, to form the anode. The fabric was then placed in a beaker of electrolyte (such as for example iron II chloride, iron II sulphate, or sodium citrate). Care was taken to ensure that only the silvered fabric is exposed to electrolyte and none of the electrical connections.

A cathode was then placed in the beaker and connected to the power supply. Nitrogen was bubbled through the fluid to degas the electrolyte, and the power supply switched on, with a 1.64- 1.25V, 240 mA, for a deposition time: 2-5 mins. This provided 5 microns of iron. The fabric was removed and washed several times with de ionised water, dried under vacuum either at room temperature for 15hrs or in an oven at 80°C for 5 hours.

### Experiment 2 Composite manufacture

Strips of iron coated fabric were cut and overlaid with standard glass fibre plies to form iron/glass/iron/glass laminate. A degassed epoxy resin was then poured on top and degassed once more in the waveguide mould. The sample was then left to cure at room temperature until cured, at least 12 hours.

## Claims

1. A ferromagnetic composite structure 10 comprising at least one ferromagnetic fibre ply 11, wherein said ferromagnetic fibre ply is substantially encapsulated in a binder matrix 12 to form a ferromagnetic fibre reinforced polymer composite, wherein said at least one ferromagnetic fibre ply comprises a fibre ply 1 comprising at least one layer of a ferromagnetic material 3, characterised wherein there is a layer of at least one metal or ionic metal compound nucleation material 2 between the fibre ply and the layer of ferromagnetic material.

2. A structure according to claim 1, wherein the ferromagnetic material is selected from iron, nickel, cobalt or alloys thereof.

3. A structure according to claim 1 or 2, wherein the nucleation material comprises silver or gold.

4. A structure according to any one of the preceding claims wherein the layer of ferromagnetic material is in the range of from 5 to 10 microns.

5. A structure according to any one of the preceding claims, wherein the layer of ferromagnetic material covers part, substantially all or all of the fibre ply.

6. A structure according to claim 5 wherein the layer of ferromagnetic material is arranged in a pattern.

7. A structure according to any one of the preceding claims wherein the composite comprises at least one further fibre ply.

8. A structure according to any one of the preceding claims, wherein the binder matrix comprises particulate fillers.

9. A structure according to claim 8, wherein the particulate fillers are ferromagnetic materials.

10. A vehicle vessel or craft comprising at least one composite structure according to any one of the preceding claims.

11. A method of manufacturing a ferromagnetic fibre-reinforced polymer composite comprising a non-conductive fibre ply, according to any one of claims 1 to 9 including the steps of providing at least one non-conductive fibre ply to be treated,
deposing at least one layer of a at least one metal or ionic metal compound nucleation material onto at least one surface of the at least one non-conductive fibre ply to be treated, to form a primed non-conductive fibre ply,
causing ionic deposition of a layer of ferromagnetic material onto said primed non-conductive fibre ply

12. A method according to claim 11, wherein the nucleation layer is a silver metal/ion loaded paint

13. A method according to claim 11 or 12, wherein the nucleation layer is deposed as a pattern on at least one surface of the at least one fibre ply to be treated.

14. A method according to any one of claims 11 to 13, wherein the ionic deposition is via electrodeposition or electroless deposition.

## Patentansprüche

1. Ferromagnetische Verbundstoffstruktur 10, umfassend wenigstens eine ferromagnetische Faserlage 11, wobei die ferromagnetische Faserlage im Wesentlichen in einer Bindemittelmatrix 12 verkapselt ist, um einen ferromagnetischen faserverstärkten Polymerverbundstoff zu bilden, wobei die wenigstens eine ferromagnetische Faserlage eine Faserlage 1 umfasst, die wenigstens eine Schicht aus einem ferromagnetischen Material 3 umfasst, **dadurch gekennzeichnet, dass** eine Schicht aus wenigstens einem Metall- oder ionische-Metallverbindung-Nukleierungsmaterial 2 zwischen der Faserlage und der Schicht aus ferromagnetischem Material angeordnet ist.

2. Struktur gemäß Anspruch 1, wobei das ferromagnetische Material ausgewählt ist aus Eisen, Nickel, Kobalt und Legierungen davon.

3. Struktur gemäß Anspruch 1 oder 2, wobei das Nukleierungsmaterial Silber oder Gold umfasst.

4. Struktur gemäß einem der vorstehenden Ansprüche, wobei die Schicht aus ferromagnetischem Material in dem Bereich von 5 bis 10 Mikrometer liegt.

5. Struktur gemäß einem der vorstehenden Ansprüche, wobei die Schicht aus ferromagnetischem Material einen Teil der, im Wesentlichen die gesamte oder die gesamte Faserlage bedeckt.

6. Struktur gemäß Anspruch 5, wobei die Schicht aus ferromagnetischem Material in einem Muster angeordnet ist.

7. Struktur gemäß einem der vorstehenden Ansprüche, wobei der Verbundstoff wenigstens eine weitere Faserlage umfasst.

8. Struktur gemäß einem der vorstehenden Ansprüche, wobei die Bindemittelmatrix partikelförmige Füllstoffe umfasst.

9. Struktur gemäß Anspruch 8, wobei die partikelförmigen Füllstoffe ferromagnetische Materialien sind.

10. Fahrzeug Schiff oder Wasserfahrzeug, umfassend wenigstens eine Verbundstoffstruktur gemäß einem der vorstehenden Ansprüche.

11. Verfahren zum Herstellen eines ferromagnetischen faserverstärkten Polymerverbundstoffs, der eine nicht-leitfähige Faserlage umfasst, gemäß einem der Ansprüche 1 bis 9, umfassend die Schritte
Bereitstellen wenigstens einer zu behandelnden nicht-leitfähigen Faserlage,
Abscheiden wenigstens einer Schicht aus wenigstens einem Metall- oder ionische-Metallverbindung-Nukleierungsmaterial auf wenigstens eine Oberfläche der wenigstens einen zu behandelnden nicht-leitfähigen Faserlage, um eine grundierte nicht-leitfähige Faserlage zu bilden,
Bewirken von ionischer Abscheidung einer Schicht aus ferromagnetischem Material auf die grundierte nicht-leitfähigen Faserlage.

12. Verfahren gemäß Anspruch 11, wobei die Nukleierungsschicht ein Silbermetall/-ionen beladener Anstrich ist.

13. Verfahren gemäß Anspruch 11 oder 12, wobei die Nukleierungsschicht als Muster auf wenigstens eine Oberfläche der wenigstens einen zu behandelnden nicht-leitfähigen Faserlage abgeschieden wird.

14. Verfahren gemäß einem der Ansprüche 11 bis 13, wobei die ionische Abscheidung über Elektroabscheidung oder stromlose Abscheidung erfolgt.

## Revendications

1. Structure composite ferromagnétique 10 comprenant au moins une couche de fibres ferromagnétiques 11, dans laquelle ladite couche de fibres ferromagnétiques est sensiblement encapsulée dans une matrice de liant 12 pour former un composite polymère renforcé par des fibres ferromagnétiques, dans laquelle ladite au moins une couche de fibres ferromagnétiques comprend une couche de fibres 1 comprenant au moins une couche d'un matériau ferromagnétique 3, **caractérisée en ce qu'**une couche d'au moins un matériau de nucléation constitué d'un métal ou d'un composé métallique ionique 2 est présente entre la couche de fibres et la couche de matériau ferromagnétique.

2. Structure selon la revendication 1, dans laquelle le matériau ferromagnétique est sélectionné parmi le fer, le nickel, le cobalt ou des alliages de ceux-ci.

3. Structure selon la revendication 1 ou 2, dans laquelle le matériau de nucléation comprend l'argent ou l'or.

4. Structure selon l'une quelconque des revendications précédentes, dans laquelle la couche de matériau ferromagnétique est de 5 à 10 microns.

5. Structure selon l'une quelconque des revendications précédentes, dans laquelle la couche de matériau ferromagnétique recouvre une partie, la quasi-totalité ou la totalité de la couche de fibres.

6. Structure selon la revendication 5, dans laquelle la couche de matériau ferromagnétique est disposée selon un motif.

7. Structure selon l'une quelconque des revendications précédentes, dans laquelle le composé comprend au moins une couche de fibres supplémentaire.

8. Structure selon l'une quelconque des revendications précédentes, dans laquelle la matrice de liant comprend des charges particulaires.

9. Structure selon la revendication 8, dans laquelle les charges particulaires sont des matériaux ferromagnétiques.

10. Véhicule, bateau ou aéronef, comprenant au moins une structure composite selon l'une quelconque des revendications précédentes.

11. Procédé de fabrication d'un composite polymère renforcé par des fibres ferromagnétiques, comprenant une couche de fibres non conductrices, selon l'une quelconque des revendications 1 à 9, comprenant les étapes qui consistent à :
former au moins une couche de fibres non conductrices à traiter,
déposer au moins une couche d'au moins un matériau de nucléation constitué d'un métal ou d'un composé métallique ionique sur au moins une surface de ladite au moins une couche de fibres non conductrices à traiter, pour former une couche de fibres non conductrices revêtue d'un apprêt,
provoquer le dépôt ionique d'une couche de matériau ferromagnétique sur ladite couche de fibres non conductrices revêtue d'un apprêt.

12. Procédé selon la revendication 11, dans lequel la couche de nucléation est une peinture contenant une charge d'argent métallique/à charge ionique.

13. Procédé selon la revendication 11 ou 12, dans lequel la couche de nucléation est déposée selon un motif sur au moins une surface de ladite au moins une couche de fibres à traiter.

14. Procédé selon l'une quelconque des revendications 11 à 13, dans lequel le dépôt ionique est réalisé par électrodéposition ou dépôt autocatalytique.
